# EUROPEAN PATENT APPLICATION

(11) **EP 4 501 994 A1**
(43) Date of publication of application: **05.02.2025**
(21) Application number: 23780383.8
(22) Date of filing: 27.03.2023
(51) Int. Cl.: C08F 290/06, C08F 2/44, C08F 20/56, C08J 5/24

(54) **DIPHENYL(METH)ACRYLAMIDE-CONTAINING THERMOSETTING RESIN COMPOSITION AND CURED PRODUCT THEREFROM**

(30) Priority: 29.03.2022 JP 2022054351
(71) Applicant: Nippon Soda Co., Ltd., Tokyo 100-7010 (JP)
(72) Inventor: YAMATE, Taiki, Ichihara-shi, Chiba 290-0045 (JP); KAWANISHI, Takuya, Ichihara-shi, Chiba 290-0045 (JP); SHIBATA, Yasuhisa, Ichihara-shi, Chiba 290-0045 (JP); TAKAHASHI, Eiji, Ichihara-shi, Chiba 290-0045 (JP)
(74) Representative: Sonnenhauser, Thomas Martin
(86) International application number: PCT/JP2023/012268
(87) International publication number: WO 2023/190374

(57) **Abstract**

It is to provide: a thermosetting resin composition having a low dielectric constant, a low dielectric loss tangent, a high glass transition point, and excellent water resistance, and a cured product therefrom.

The thermosetting resin composition of the present invention comprises the following components (A) and (B).
(A) a compound of formula (I)
(X¹ and X² each independently represent a C1-C20 alkyl group or the like, n1 and n2 each independently represent 0 or 1, Z¹ and Z² each independently represent a single bond or the like, X³ and X⁴ each independently represent an organic group or the like, m1 and m2 each independently represent any integer from 0 to 4, and Y represents a polymerizable functional group)
(B) a maleimide compound having one or more maleimide groups, a polyphenylene ether compound, polybutadiene, a styrene-butadiene-styrene block copolymer, or a polymer having a repeat unit of formula (III) (Z³ represents a C6-C12 arylene group, and R² to R⁷ each independently represent a hydrogen atom or the like)

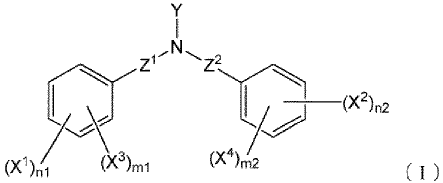

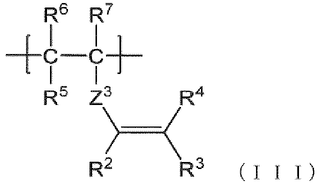

## Description

### Technical Field

The present invention relates to a thermosetting resin composition having excellent heat resistance, water resistance, and dielectric properties, and a cured product therefrom.

The present application claims priority to Japanese Patent Application No. 2022-54351 filed on March 29, 2022, the contents of which are incorporated herein by reference.

### Background Art

Various known resins are used to produce mobile communication devices such as mobile phones and smart phones, the base station devices thereof, network-related electronic devices such as servers and routers, printed wiring boards in large-scale computers, and the like.

In recent years, the above network-related electronic devices have been required to transmit and process large volumes of information with low loss and at high speed, and the electrical signals handled by the printed wiring boards of these products are also becoming increasingly high-frequency. As high-frequency electrical signals are more susceptible to attenuation, transmission loss in the printed wiring boards needs to be further reduced. Therefore, the resins used in the production of printed wiring boards are required to have a low dielectric constant and a low dielectric loss tangent. In addition, the resins used in the production of printed wiring boards are also required to have a high heat resistance (high glass transition point).

Patent Document 1 describes that an adhesive composition using a polymer of N,N-[4,4'-bis(α,α-dimethylbenzyl)diphenyl]acrylamide can be a coating agent with excellent adhesion and adherence.

Patent Document 2 describes that a polymer of N,N-bis(4-(1,1,3,3-tetramethylbutyl)phenyl)acrylamide is an adhesive composition with excellent adhesion and adherence.

### Prior Art Documents

### Patent Documents

Patent Document 1: WO 2018/070079 pamphlet
Patent Document 2: WO 2020/071456 pamphlet

### Summary of the Invention

### Object to be Solved by the Invention

An object of the present invention is to provide: a thermosetting resin composition having a low dielectric constant, a low dielectric loss tangent, a high glass transition point, and excellent water resistance, and a cured product therefrom.

### Means to Solve the Object

As a result of extensive studies, the present inventors have found that the above object can be solved by using a polymerizable compound such as diphenyl(meth)acrylamide or a derivative thereof in combination with a specific compound such as a polyphenylene ether compound.

That is, the present invention relates to the following inventions.
(1) A thermosetting resin composition comprising:
   (A) at least one compound of formula (I): 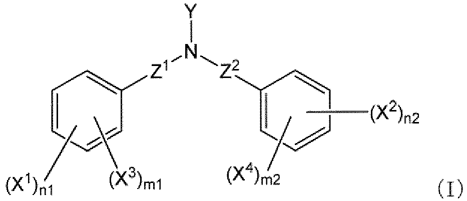 (wherein
      X¹ and X² each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group,
      n1 and n2 each independently represent 0 or 1,
      Z¹ and Z² each independently represent a single bond or a C1-C3 alkylene group,
      X³ and X⁴ each independently represent an organic group or a halogeno group,
      m1 and m2 each independently represent any integer from 0 to 4, and
      Y represents a polymerizable functional group), and
   (B) at least one of the following (B-1) to (B-5):
      (B-1) a maleimide compound having one or more maleimide groups;
      (B-2) a polyphenylene ether compound;
      (B-3) polybutadiene having a molar ratio of 1,2-bond structure to 1,4-bond structure of 80:20 to 100:0;
      (B-4) a styrene-butadiene-styrene block copolymer (SBS) having a molar ratio of 1,2-bond structure to 1,4-bond structure in the butadiene block of 80:20 to 100:0; and
      (B-5) a polymer having a repeat unit of formula (III) in the molecule: 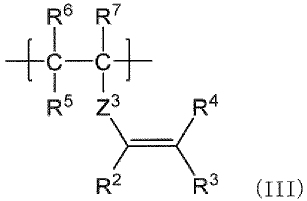 (wherein Z³ represents a C6-C12 arylene group, R² to R⁴ each independently represent a hydrogen atom or a C1-C6 alkyl group, and R⁵ to R⁷ each independently represent a hydrogen atom or a C1-C6 alkyl group).
(2) The thermosetting resin composition according to (1), further comprising (C) a radical polymerization initiator.
(3) The thermosetting resin composition according to (1) or (2), wherein the compound of formula (I) is a compound of formula (II): 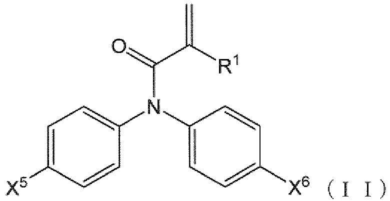 (wherein
   X⁵ and X⁶ each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group, and
   R¹ represents a hydrogen atom or a methyl group).
(4) A cured product made by curing the thermosetting resin composition according to any one of (1) to (3).
(5) The thermosetting resin composition according to any one of (1) to (3), wherein the thermosetting resin composition is a resin composition for the insulating layer of a printed wiring board.
(6) A resin varnish comprising the thermosetting resin composition according to any one of (1) to (3).
(7) A prepreg comprising a substrate impregnated with the thermosetting resin composition according to any one of (1) to (3).
(8) An adhesive film having a resin composition layer comprising the thermosetting resin composition according to any one of (1) to (3) on a support film.
(9) A metal foil with a thermosetting resin composition, having a resin composition layer comprising the thermosetting resin composition according to any one of (1) to (3) on the metal foil.
(10) A laminate with a metal foil, comprising: a layer of a cured product of the thermosetting resin composition according to any one of (1) to (3); and a metal foil.

### Effect of the Invention

The thermosetting resin composition of the present invention has a high glass transition point, a low dielectric constant and a low dielectric loss tangent, and exhibits excellent water resistance.

### Mode of Carrying Out the Invention

### <Component (A)>

The thermosetting resin composition of the present invention comprises (A) at least one compound of formula (I) .

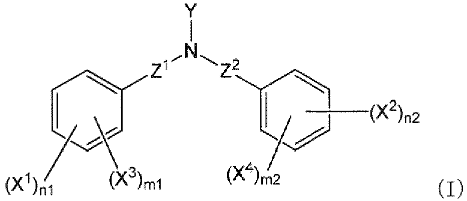

In formula (I), X¹ and X² each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group.

As the C1-C20 alkyl group of X¹ and X², a C1-20 linear alkyl group or a C3-20 branched alkyl group may be exemplified.

As a C1-20 linear alkyl group, a methyl group, an ethyl group, an n-propyl group, an n-butyl group, an n-pentyl group, an n-hexyl group, an n-heptyl group, an n-octyl group, an n-nonyl group, an n-decyl group, an n-dodecyl group, an n-tridecyl group, an n-tetradecyl group, an n-hexadecyl group, an n-octadecyl group, an n-eicosyl group, or the like may be exemplified.

As a C3-20 branched alkyl group, an isopropyl group, a sec-butyl group, an isobutyl group, a tert-butyl group, a neopentyl group, an isopentyl group, a sec-pentyl group, a 1-ethylpropyl group, a tert-pentyl group, an isohexyl group, a 3-methylpentyl group, a 2,2-dimethylbutyl group, a 2,3-dimethylbutyl group, a 1,1,2,2-tetramethylpropyl group, a 1,1,3-trimethylbutyl group, a 1-ethylpentyl group, a 1,1,3,3-tetramethylbutyl group, a 2,2,3,3-tetramethylbutyl group, a 1,2,4-trimethylpentyl group, a 2,4,4-trimethylpentyl group, a 2,2,4-trimethylpentyl group, a 1-ethyl-4-methylpentyl group, a 3-ethyl-3-methylpentyl group, a 3-ethyl-4-methylpentyl group, a 1-ethyl-1-methylpentyl group, a 1,1-dimethylhexyl group, a 3,3-dimethylhexyl group, a 4,4-dimethylhexyl group, a 2-ethylhexyl group, a 3-ethylhexyl group, a 6-methylheptyl group, a 1,3,5-trimethylhexyl group, a 1,1,3-trimethylhexyl group, a 1-butyl-1-methylheptyl group, a 1-methylheptyl group, a 1-methyl-1-octylundecyl group, or the like may be exemplified.

As the C1-C20 alkoxy group of X¹ and X², a C1-20 linear alkoxy group or a C3-20 branched alkoxy group may be exemplified.

As a C1-20 linear alkoxy group, a methoxy group, an ethoxy group, an n-propyloxy group, an n-butyloxy group, an n-pentyloxy group, an n-heptyloxy group, an n-octyloxy group, an n-nonyloxy group, an n-decyloxy group, an n-dodecyloxy group, an n-tridecyloxy group, an n-tetradecyloxy group, an n-hexadecyloxy group, an n-octadecyloxy group, an n-eicosyloxy group, or the like may be exemplified.

As a C3-20 branched alkoxy group, an isopropyloxy group, a sec-butyloxy group, an isobutyloxy group, a tert-butyloxy group, a neopentyloxy group, an isopentyloxy group, a sec-pentyloxy group, a 1-ethylpropyloxy group, a tert-pentyloxy group, an isohexyloxy group, a 3-methylpentyloxy group, a 2,2-dimethylbutyloxy group, a 2,3-dimethylbutyloxy group, a 1,1,2,2-tetramethylpropyloxy group, a 1,1,3-trimethylbutyloxy group, a 1-ethylpentyloxy group, a 1,1,3,3-tetramethylbutyloxy group, a 2,2,3,3-tetramethylbutyloxy group, a 1,2,4-trimethylpentyloxy group, a 2,4,4-trimethylpentyloxy group, a 2,2,4-trimethylpentyloxy group, a 1-ethyl-4-methylpentyloxy group, a 3-ethyl-3-methylpentyloxy group, a 3-ethyl-4-methylpentyloxy group, a 1-ethyl-1-methylpentyloxy group, a 1,1-dimethylhexyloxy group, a 3,3-dimethylhexyloxy group, a 4,4-dimethylhexyloxy group, a 2-ethylhexyloxy group, a 3-ethylhexyloxy group, a 6-methylheptyloxy group, a 1,3,5-trimethylhexyloxy group, a 1,1,3-trimethylhexyloxy group, a 1-butyl-1-methylheptyloxy group, a 1-methylheptyloxy group, a 1-methyl-1-octylundecyloxy group, or the like may be exemplified.

As the C3-C6 cyclic alkyl group of X¹ and X², a cyclopropyl group, a cyclobutyl group, a cyclopentyl group, a cyclohexyl group, or the like may be exemplified.

As the C3-C6 cyclic alkoxy group of X¹ and X², a cyclopropyloxy group, a cyclobutyloxy group, a cyclopentyloxy group, a cyclohexyloxy group, or the like may be exemplified.

In formula (I), n1 and n2 each independently represent 0 or 1.

### n1 and n2 each preferably represent 1.

In formula (I), Z¹ and Z² each independently represent a single bond or a C1-C3 alkylene group.

As the C1-C3 alkylene group of Z¹ and Z², a methylene group, an ethylene group, a propane-1,3-diyl group, or the like may be exemplified.

Z¹ and Z² each preferably represent a single bond.

In formula (I), X³ and X⁴ each independently represent an organic group or a halogeno group. The organic group of X³ and X⁴ is not particularly limited as long as it is chemically acceptable and has the effects of the present invention. As an organic group, a C1-6 alkyl group such as a methyl group, an ethyl group, an n-propyl group, an i-propyl group, an n-butyl group, an s-butyl group, an i-butyl group, a t-butyl group, an n-pentyl group, and an n-hexyl group, a C6-10 aryl group such as a phenyl group and a naphthyl group, a C1-6 alkoxy group such as a methoxy group, an ethoxy group, an n-propoxy group, an i-propoxy group, an n-butoxy group, an s-butoxy group, an i-butoxy group, and a t-butoxy group, a C1-6 haloalkyl group such as a chloromethyl group, a chloroethyl group, a trifluoromethyl group, a 1,2-dichloro-n-propyl group, a 1-fluoro-n-butyl group, and a perfluoro-n-pentyl group, or the like may be exemplified.

As the halogeno group of X³ and X⁴, a fluoro group, a chloro group, a bromo group, and an iodo group may be exemplified.

In formula (I), m1 and m2 each independently represent any integer from 0 to 4.

m1 and m2 each preferably represent 0.

In formula (I), Y represents a polymerizable functional group. As a polymerizable functional group, a group having a polymerizable carbon-carbon double bond such as a vinyl group, an allyl group, an acryloyl group, a methacryloyl group, a vinyloxycarbonyl group, a prop-1-en-2-yloxycarbonyl group, and an allyloxycarbonyl group, or the like may be exemplified.

In the present invention, as Y, an acryloyl group and a methacryloyl group are preferred.

The compound of formula (I) is preferably a compound of formula (II).

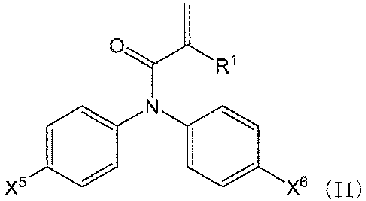

In formula (II), X⁵ and X⁶ each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group.

The C1-C20 alkyl group, C1-C20 alkoxy group, C3-C6 cyclic alkyl group, and C3-C6 cyclic alkoxy group of X⁵ and X⁶ include the same as those exemplified in X¹ and X².

In formula (II), R¹ represents a hydrogen atom or a methyl group.

X⁵ and X⁶ each preferably represent a C1-C20 alkyl group, a benzyl group, or an α,α-dimethylbenzyl group, more preferably a C3-20 branched alkyl group, or an α,α-dimethylbenzyl group, and even more preferably a tert-butyl group, a 1,1,3,3-tetramethylbutyl group, or an α,α-dimethylbenzyl group.

The method for producing the compound of formula (I) used in the present invention is not particularly limited, and the compound may be obtained using a known chemical reaction. For example, the compound of formula (I) may be produced by the methods described in the WO 2018/070079 pamphlet, WO 2020/071456 pamphlet, WO 2021/201207 pamphlet, and WO 2021/201208 pamphlet.

### <Component (B)>

The thermosetting resin composition of the present invention comprises at least one of the following (B-1) to (B-5):
(B-1) a maleimide compound having one or more maleimide groups
(B-2) a polyphenylene ether compound
(B-3) polybutadiene having a molar ratio of 1,2-bond structure to 1,4-bond structure of 80:20 to 100:0,
(B-4) a styrene-butadiene-styrene block copolymer (SBS) having a molar ratio of 1,2-bond structure to 1,4-bond structure in the butadiene block of 80:20 to 100:0
(B-5) a polymer having a repeat unit of formula (III) in the molecule: 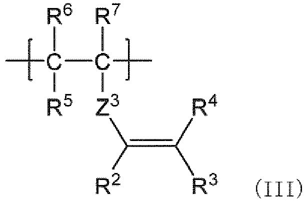 (wherein Z³ represents a C6-C12 arylene group, R² to R⁴ each independently represent a hydrogen atom or a C1-C6 alkyl group, and R⁵ to R⁷ each independently represent a hydrogen atom or a C1-C6 alkyl group).

### <Component (B-1)>

As the maleimide compound having one or more maleimide groups used in the present invention, N-phenylmaleimide, N-hydroxyphenylmaleimide, bis(4-maleimidophenyl)methane, 2,2-bis{4-(4-maleimidophenoxy)-phenyl}propane, bis(3,5-dimethyl-4-maleimidophenyl)methane, bis(3-ethyl-5-methyl-4-maleimidophenyl)methane, bis(3,5-diethyl-4-maleimidophenyl)methane, polytetramethylene oxide-bis(4-maleimidobenzoate), 2,2-bis[4-(4-maleimidophenoxy)phenyl]propane, a compound of the following formula (IV), a compound of the following formula (VI), a prepolymer of these maleimide compounds, and a prepolymer of a maleimide compound and an amine compound may be exemplified. These compounds may be used alone or used by appropriately mixing two or more thereof.

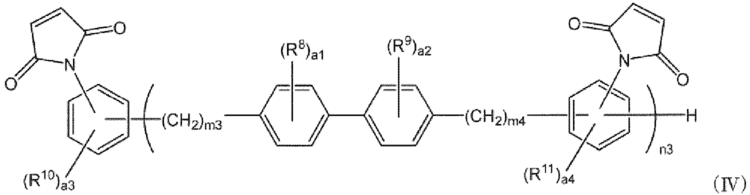

In formula (IV),
R⁸ and R⁹ each independently represent a halogeno group, a C1-C6 alkyl group, a hydroxyl group, a C1-C6 alkoxy group, a formyl group, a carboxyl group, a C1-C6 alkoxycarbonyl group, a C6-C10 aryl group, an amino group, a C1-C6 alkyl group-substituted amino group, a cyano group, or a nitro group;
a1 and a2 each independently represent an integer of 0 to 4, the R⁸s may be the same or different from each other when a1 is 2 or more, and the R⁹s may be the same or different from each other when a2 is 2 or more;
m3 and m4 each independently represent an integer of 1 to 10;
R¹⁰ and R¹¹ each independently represent a C1-C6 alkyl group or a C6-C10 aryl group;
a3 represents an integer of 0 to 3, and the R¹⁰s may be the same or different from each other when a3 is 2 or more;
a4 represents an integer of 0 to 2, and the R¹¹s may be the same or different from each other when a4 is 2 or more; and
n3 represents an integer of 1 to 100.

As the halogeno group of R⁸ and R⁹, a fluoro group, a chloro group, a bromo group, an iodo group, or the like may be exemplified.

The C1-C6 alkyl group of R⁸ and R⁹ may be linear or branched. As a C1-C6 alkyl group, a methyl group, an ethyl group, an n-propyl group, an n-butyl group, an n-pentyl group, an n-hexyl group, an i-propyl group, an i-butyl group, an s-butyl group, a t-butyl group, an i-pentyl group, a neopentyl group, a 2-methylbutyl group, a 2,2-dimethylpropyl group, an i-hexyl group, or the like may be exemplified.

As the C1-C6 alkoxy group of R⁸ and R⁹, a methoxy group, an ethoxy group, an n-propoxy group, an i-propoxy group, an n-butoxy group, an s-butoxy group, an i-butoxy group, a t-butoxy group, or the like may be exemplified.

As the C1-C6 alkoxycarbonyl group of R⁸ and R⁹, a methoxycarbonyl group, an ethoxycarbonyl group, an n-propoxycarbonyl group, an i-propoxycarbonyl group, an n-butoxycarbonyl group, a t-butoxycarbonyl group, or the like may be exemplified.

As the C6-C10 aryl group of R⁸ and R⁹, a phenyl group, a naphthyl group, or the like may be exemplified.

The C1-C6 alkyl group-substituted amino group of R⁸ and R⁹ may be either mono-substituted or di-substituted. As a C1-C6 alkyl group-substituted amino group, a methylamino group, a dimethylamino group, an ethylamino group, a diethylamino group, a methyl ethylamino group, or the like may be exemplified.

a1 and a2 each preferably represent 0.

m3 and m4 each preferably represent 1 to 6, more preferably 1 to 3, even more preferably 1 or 2, and particularly preferably 1.

The C1-C6 alkyl group and C6-C10 aryl group of R¹⁰ and R¹¹ include the same as those exemplified in R⁸ and R⁹.

a3 and a4 each preferably represent 0.

n3 preferably represents 1 to 50, more preferably 1 to 20, and even more preferably 1 to 5.

As the compound of formula (IV), specifically, the compound of formula (V) may be exemplified.

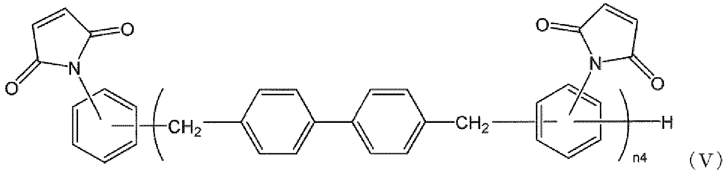

In formula (V), n4 represents any integer from 1 to 100.

n4 represents preferably 1 to 50, more preferably 1 to 20, and even more preferably 1 to 5.

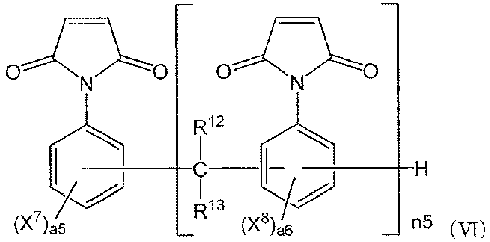

In formula (VI), R¹² and R¹³ each independently represent a hydrogen atom or a C1-C6 alkyl group; n5 represents an integer of 1 to 10; X⁷ and X⁸ each independently represent a C1-C6 alkyl group; a5 and a6 each independently represent any integer from 0 to 2, the X⁷s may be the same or different from each other when a5 is 2 or more, and the X⁸s may be the same or different from each other when a6 is 2 or more.

The C1-C6 alkyl group of R¹² and R¹³ includes the same as those exemplified in R⁸ and R⁹.

R¹² and R¹³ each preferably represent a hydrogen atom or a methyl group, and more preferably a hydrogen atom.

n5 preferably represents an integer of 1 to 7, more preferably an integer of 1 to 3, and even more preferably 1.

The C1-C6 alkyl group of X⁷ and X⁸ includes the same as those exemplified in R⁸ and R⁹.

X⁷ and X⁸ each preferably represent a methyl group or an ethyl group.

The compound of formula (VI) is preferably 4,4'-diphenylmethane bismaleimide or bis(3-ethyl-5-methyl-4-maleimidophenyl)methane.

The maleimide compound used in the present invention is preferably a compound of formula (IV) or a compound of formula (VI), and more preferably a compound of formula (V) or a compound of formula (VI).

The maleimide compound used may be a commercial product. As a commercial product, MIR-3000 (manufactured by Nippon Kayaku Co., Ltd.), MIR-3000-70MT (manufactured by Nippon Kayaku Co., Ltd.), BMI (manufactured by K·I Chemical Industry Co., Ltd.), BMI-70 (manufactured by K·I Chemical Industry Co., Ltd.), BMI-80 (manufactured by K·I Chemical Industry Co., Ltd.), or the like may be exemplified.

### <Component (B-2)>

The polyphenylene ether compound used in the present invention is not particularly limited as long as it is a polymer having a repeat unit of the following formula (VII):

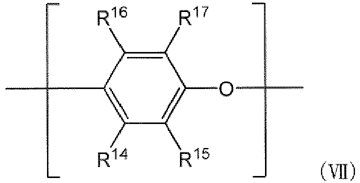

In formula (VII), R¹⁴ to R¹⁷ each independently represent a hydrogen atom, a C1-C6 alkyl group, a C2-C6 alkenyl group, a C2-C6 alkynyl group, a C1-C6 alkylcarbonyl group, or a C2-C6 alkenylcarbonyl group.

The C1-C6 alkyl group of R¹⁴ to R¹⁷ includes the same as those exemplified in R⁸ and R⁹.

As the C2-C6 alkenyl group of R¹⁴ to R¹⁷, a vinyl group, an allyl group, or the like may be exemplified.

As the C2-C6 alkynyl group of R¹⁴ to R¹⁷, an ethynyl group, a 2-propynyl group, or the like may be exemplified.

As the C1-C6 alkylcarbonyl group of R¹⁴ to R¹⁷, an acetyl group, or the like may be exemplified.

As the C2-C6 alkenylcarbonyl group of R¹⁴ to R¹⁷, an acryloyl group, a methacryloyl group, or the like may be exemplified.

R¹⁴ to R¹⁷ each preferably represent a hydrogen atom, a C1-C6 alkyl group, or a C2-C6 alkenyl group, more preferably a hydrogen atom, a methyl group, or an allyl group, and even more preferably a hydrogen atom or a methyl group.

The polyphenylene ether compound used in the present invention may have modified terminals. As a terminal-modified polyphenylene ether compound, a polyphenylene ether compound whose terminals are modified with hydroxyl groups, and a polyphenylene ether compound modified with a substituent having a carbon-carbon unsaturated double bond may be exemplified. The polyphenylene ether compound used in the present invention is preferably a polyphenylene ether compound whose terminal is modified with a substituent having a carbon-carbon unsaturated double bond.

As the substituent having a carbon-carbon unsaturated double bond, a group of formula (VIII), an acryloyl group, or a methacryloyl group may be exemplified.

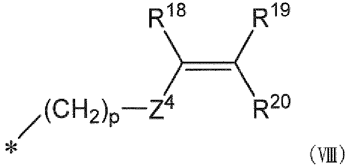

In formula (VIII), * represents a bond position, p represents an integer of 0 to 10, Z⁴ represents a C6-C12 arylene group, and R¹⁸ to R²⁰ each independently represent a hydrogen atom or a C1-C6 alkyl group.

As the C6-C12 arylene group of Z⁴, a phenylene group, or the like may be exemplified.

The C1-C6 alkyl group of R¹⁸ to R²⁰ includes the same as those exemplified in R⁸ and R⁹.

As the group of formula (VIII), specifically, a group of formula (VIII-1) or formula (VIII-2) may be exemplified.

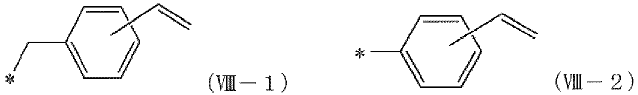

In formula (VIII-1) and formula (VIII-2), * represents a bond position.

As the polyphenylene ether compound whose terminal is modified with a substituent having a carbon-carbon unsaturated double bond, specifically, a compound of formula (IX) or formula (X) may be exemplified.

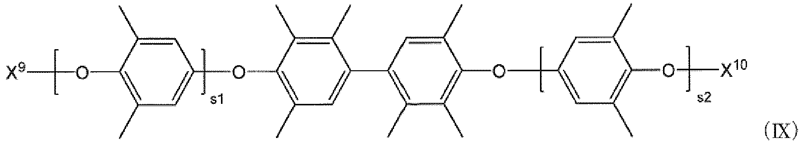

In formula (IX), X⁹ and X¹⁰ each independently represent a group of formula (VIII), an acryloyl group, or a methacryloyl group, and S1 and S2 each independently represent an integer of 0 to 20. The group of formula (VIII) of X⁹ and X¹⁰ is as described above. 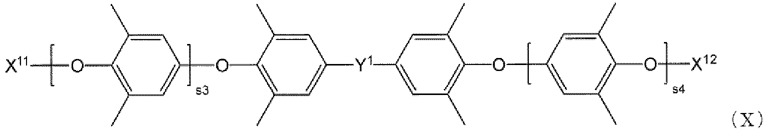 In formula (X), X¹¹ and X¹² each independently represent a group of formula (VIII), an acryloyl group, or a methacryloyl group, S3 and S4 each independently represent an integer of 0 to 20, and Y¹ represents a C1-C6 alkylene group or a single bond. The group of formula (VIII) of X¹¹ and X¹² is as described above. As the C1-C6 alkylene group of Y¹, a methylene group, an ethylene group, a methylmethylene group, a dimethylmethylene group, or the like may be exemplified.

The number average molecular weight (Mn) of the polyphenylene ether compound used is not particularly limited, but 1,000 to 7,000, 1,000 to 5,000, 1,000 to 3,000, or the like may be exemplified. The number average molecular weight (Mn) is the value obtained by converting the data measured by gel permeation chromatography (GPC) using tetrahydrofuran as a solvent, based on the molecular weight of standard polystyrene.

In addition, as the intrinsic viscosity of the polyphenylene ether compound used in the present invention, 0.03 to 0.12 dl/g, 0.04 to 0.11 dl/g, 0.06 to 0.095 dl/g, or the like may be exemplified. The intrinsic viscosity is the intrinsic viscosity measured in methylene chloride at 25°C. More specifically, it is the value obtained by measuring a methylene chloride solution (liquid temperature: 25°C) of 0.18 g/45 ml with a viscometer.

As the polyphenylene ether compound used in the present invention, a known compound or a commercial product may be used. As a commercial product, SA90 (manufactured by SABIC), SA9000 (manufactured by SABIC), OPE-2st (manufactured by Mitsubishi Gas Chemical Company), or the like may be exemplified.

If synthesized, it may be synthesized by the method described in WO 2014/203511 or the like, and the methods based thereon.

### <Component (B-3)>

The polybutadiene used in the present invention consists of only the 1,2-bond structure of formula (1), or of the 1,2-bond structure of formula (1) and the 1,4-bond structure of formula (2).

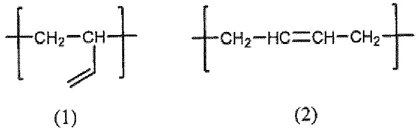

The ratio of 1,2-bond structures of formula (1) to 1,4-bond structures of formula (2) in the polybutadiene is not particularly limited, but the molar ratio of 1,2-bond structures to 1,4-bond structures in all repeat units of the polybutadiene is preferably 80:20 to 100:0.

The molecular weight of the polybutadiene used is not particularly limited, but the weight average molecular weight (Mw) may be selected within the ranges of 500 to 10,000, 500 to 8,000, 500 to 6,000, and 500 to 5,000. The weight average molecular weight (Mw) is the value obtained by converting the data measured by gel permeation chromatography (GPC) using tetrahydrofuran as a solvent, based on the molecular weight of standard polystyrene.

The polybutadiene may be a polybutadiene whose main chain and terminals are modified, or a polybutadiene whose main chain and terminals are not modified. Of these, a polybutadiene whose main chain and terminals are not modified is preferably used from the viewpoint of obtaining a cured product having high insulation properties.

The polybutadiene used may be a commercial product. As a commercial product of polybutadiene, NISSO-PB B-1000 (manufactured by Nippon Soda Co., Ltd.), NISSO-PB B-2000 (manufactured by Nippon Soda Co., Ltd.), NISSO-PB B-3000 (manufactured by Nippon Soda Co., Ltd.), or the like may be exemplified. These polybutadienes may be used alone or used by combination of two or more thereof.

### <Component (B-4)>

The styrene block in the styrene-butadiene-styrene block copolymer (SBS) used in the thermosetting resin composition of the present invention is a block of polymerized styrene, and the butadiene block is a block of polymerized butadiene. The butadiene block consists of only the 1,2-bond structure of formula (1), or of the 1,2-bond structure of formula (1) and the 1,4-bond structure of formula (2).

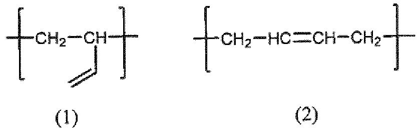

The molar ratio of 1,2-bond structures of formula (1) and 1,4-bond structures of formula (2) contained in the styrene-butadiene-styrene block copolymer used in the thermosetting resin of the present invention is 80:20 to 100:0.

The weight ratio of styrene block to butadiene block in the styrene-butadiene-styrene block copolymer is not particularly limited, but 10:90 to 80:20, 10:90 to 70:30, 10:90 to 60:40, 20:80 to 80:20 30:70 to 80:20, and 40:60 to 80:20 may be exemplified.

The weight average molecular weight (Mw) of the styrene-butadiene-styrene block copolymer is not particularly limited, but 2,000 to 100,000, 2,000 to 80,000, 2,000 to 60,000, or the like may be exemplified. The molecular weight distribution (Mw/Mn) of the styrene-butadiene-styrene block copolymer is not particularly limited, but 1.00 to 3.00, 1.00 to 2.00, or the like may be exemplified. The weight average molecular weight (Mw) and molecular weight distribution (Mw/Mn) are measured by gel permeation chromatography (GPC) using polystyrene as a standard material. The measurement conditions are: mobile phase of THF (tetrahydrofuran), mobile phase flow rate of 1 mL/min, column temperature of 40°C, sample injection volume of 40 µL, and sample concentration of 2% by weight.

The method for producing the styrene-butadiene-styrene block copolymer used is not particularly limited. For example, it may be produced by the methods described in Japanese unexamined Patent Application Publication No. H6-192502, Japanese unexamined Patent Application Publication (Translation of PCT Application) No. 2000-514122, Japanese unexamined Patent Application Publication No. 2007-302901, WO 2021/024679, or the like, and the methods based thereon.

### <Component (B-5)>

The thermosetting resin composition of the present invention may contain, as component (B), a polymer having a repeat unit of formula (III) in the molecule.

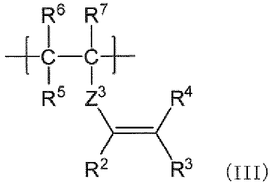

In formula (III), Z³ represents a C6-C12 arylene group, and R² to R⁷ each independently represent a hydrogen atom or a C1-C6 alkyl group.

The C6-C12 arylene group of Z³ includes the same as those exemplified in Z⁴.

The C1-C6 alkyl group of R² to R⁷ includes the same as those exemplified in R⁸ and R⁹.

As the formula (III), specifically, the formula (III-1) may be exemplified.

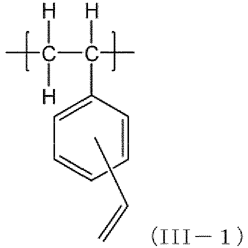

The polymer having a repeat unit of formula (III) in the molecule may be a polymer further having a repeat unit of the following formula (3) in the molecule.

The polymer may also further have a repeat unit other than the repeat unit of formula (III) and the repeat unit of formula (3).

That is, the polymer having a repeat unit of formula (III) in the molecule of component (B-5) includes the following polymers:
i) a polymer consisting of one or more repeat units of formula (III)
ii) a polymer consisting of one or more repeat units of formula (III) and one or more repeat units of formula (3)
iii) a polymer consisting of one or more repeat units of formula (III), one or more repeat units of formula (3), and repeat units other than these.

Of these polymers, the copolymers may be random copolymers or block copolymers.

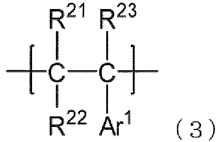

In formula (3), R²¹ to R²³ each independently represent a hydrogen atom or a C1-C6 alkyl group, and Ar¹ represents a C1-C6 alkyl group-substituted or unsubstituted C6-C12 aryl group.

The C1-C6 alkyl group of R²¹ to R²³ includes the same as those exemplified in R⁸ and R⁹.

As the C6-C12 aryl group of Ar¹, a phenyl group, a naphthyl group, a biphenyl group, or the like may be exemplified.

The C1-C6 alkyl group, which is a substituent on Ar¹ includes the same as those exemplified in R⁸ and R⁹.

As the formula (3), specifically, the formula (3-1), the formula (3-2), or the like may be exemplified.

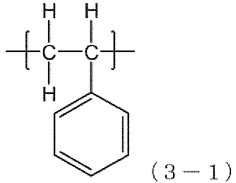

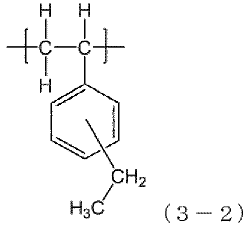

Specific examples of the polymer having a repeat unit of formula (III) in the molecule include a polymer containing a repeat unit of formula (III-1) in the molecule and further containing at least one of a repeat unit of formula (3-1) and a repeat unit of formula (3-2). This polymer may be a block copolymer or a random copolymer.

The weight average molecular weight of the polymer having a repeat unit of formula (III) in the molecule is preferably 1,200 to 40,000, and more preferably 1,200 to 35,000. If the weight average molecular weight is too high, the formability and the like tend to decrease. Therefore, when the resin composition has a weight average molecular weight within the above range, it has excellent heat resistance and formability. Here, the weight average molecular weight may be measured by a general molecular weight measurement, and specifically, a value measured using gel permeation chromatography (GPC) or the like may be exemplified.

In the polymer having a repeat unit of formula (III) in the molecule, the molar content of the repeat unit of formula (III) is preferably 2 to 95 mol% and more preferably 8 to 81 mol% when the total of repeat units in the polymer having a repeat unit of formula (III) in the molecule is defined as 100 mol%.

In addition, when the polymer having a repeat unit of formula (III) in the molecule is a polymer having a repeat unit of formula (III) and a repeat unit of the following formula (3) in the molecule, the molar content of the repeat unit of formula (III) is preferably 2 to 95 mol% and more preferably 8 to 81 mol%, and the molar content of the repeat unit of formula (3) is preferably 5 to 98 mol% and more preferably 19 to 92 mol%.

### <Component (C)>

The thermosetting resin composition of the present invention may further comprise (C) a radical polymerization initiator.

The radical polymerization initiator used in the thermosetting resin composition of the present invention includes azo initiators and peroxide initiators.

As an azo initiator, azobisisobutyronitrile, 1,1'-azobis(cyclohexane-1-carbonitrile), 2,2'-azobis{2-methyl-N-[1,1-bis(hydroxymethyl)ethyl]propionamide}, 2,2'-azobis[2-methyl-N-(2-hydroxyethyl)propionamide], 2,2'-azobis[2-(hydroxymethyl)propionitrile], 2,2'-azobis(2,4-dimethylvaleronitrile), 2,2'-azobis(4-methoxy-2,4-dimethylvaleronitrile), dimethyl 2,2'-azobis(isobutyrate), 2,2'-azobis[2-(2-imidazolin-2-yl)propane], 2,2'-azobis{2-methyl-N-[1,1-bis(hydroxymethyl)-2-hydroxyethyl]propionamide}, or the like may be exemplified.

Peroxide initiators include, but are not limited to, peroxides such as benzoyl peroxide, cumene hydroperoxide, 2,5-dimethylhexane-2,5-dihydroperoxide, α,α'-di(t-butylperoxy)diisopropylbenzene, 2,5-dimethyl-2,5-di(t-butylperoxy)hexyne-3, di-t-butyl peroxide, t-butyl cumyl peroxide, α,α'-bis(t-butylperoxy-m-isopropyl)benzene, 2,5-dimethyl-2,5-di(t-butylperoxy)hexane, dicumyl peroxide, dit-butyl peroxyisophthalate, t-butyl peroxybenzoate, 2,2-bis(t-butylperoxy)butane, 2,2-bis(t-butylperoxy)octane, 2,5-dimethyl-2,5-di(benzoylperoxy)hexane, di(trimethylsilyl)peroxide, trimethylsilyl triphenylsilyl peroxide, and diisopropyl benzene hydroperoxide. Although not a peroxide, 2,3-dimethyl-2,3-diphenylbutane may also be used as a radical polymerization initiator (or polymerization catalyst). However, the radical polymerization initiator used for curing the resin composition of the present invention is not limited to these examples.

The radical polymerization initiator used in the thermosetting resin composition of the present invention is preferably a peroxide polymerization initiator.

### <Other Components>

The thermosetting resin composition of the present invention may contain other components, if necessary, as long as the effects of the present invention are not impaired. As other components, an organic solvent, a cross-linking agent, a thermoplastic resin, an inorganic filler, an organic filler, a flame retardant, other additives, or the like may be exemplified.

As an organic solvent, amide-based, ether-based, ester-based, aliphatic hydrocarbon-based, aromatic hydrocarbon-based, ketone-based, and organic halogen compound-based solvents may be exemplified.

As an amide-based organic solvent, N,N-dimethylformamide (DMF) and N,N-dimethylacetamide; as an ether-based organic solvent, diethyl ether, dipropyl ether, dibutyl ether, diamyl ether, and tetrahydrofuran; as an ester-based organic solvent, ethyl acetate, propyl acetate, butyl acetate, amyl acetate, heptyl acetate, ethyl butyrate, isoamyl isovalerate, and propylene glycol methyl ether acetate; as an aliphatic hydrocarbon-based organic solvent, normal hexane, normal heptane, and cyclohexane; as an aromatic hydrocarbon-based organic solvent, toluene and xylene; as a ketone-based organic solvent, methyl ethyl ketone, methyl isobutyl ketone, and cyclohexanone; and as an organic halide-based organic solvent, trichloroethane and trichloroethylene may be exemplified. In addition, a relatively inert organic solvent such as propylene glycol monomethyl ether and propylene glycol monoethyl ether may be used.

As a cross-linking agent, a polyfunctional vinyl compound such as divinylbenzene, divinylnaphthalene and divinylbiphenyl; a vinylbenzyl ether compound synthesized from the reaction of a phenol and vinylbenzyl chloride; a styrene monomer; an allyl ether compound synthesized from the reaction of a phenol and an allyl chloride; a trialkenyl isocyanurate such as triallyl isocyanurate (TAIC (registered trademark)) and triallyl cyanurate (TAC); a (meth)acrylate compound (methacrylate and acrylate compounds) such as trimethylolpropane; a compound having an acenaphthylene backbone, or the like may be exemplified. Using these cross-linking agents allows to increase heat resistance. The cross-linking agent may be used alone or used by combination of two or more thereof.

As the compound having an acenaphthylene backbone, acenaphthylene; a hydroxyacenaphthylene compound such as 3-hydroxyacenaphthylene, 4-hydroxyacenaphthylene, 5-hydroxyacenaphthylene, and 5,6-dihydroxyacenaphthylene; an alkylacenaphthylene compound such as 3-methylacenaphthylene, 3-ethylacenaphthylene, 3-propylacenaphthylene, 4-methylacenaphthylene, 4-ethylacenaphthylene, 4-propylacenaphthylene, 5-methylacenaphthylene, 5-ethylacenaphthylene, 5-propylacenaphthylene, 3,8-dimethylacenaphthylene, and 5,6-dimethylacenaphthylene; an alkoxyacenaphthylene compound such as 3-methoxyacenaphthylene, 3-ethoxyacenaphthylene, 3-butoxyacenaphthylene, 4-methoxyacenaphthylene, 4-ethoxyacenaphthylene, 4-butoxyacenaphthylene, 5-methoxyacenaphthylene, 5-ethoxyacenaphthylene, and 5-butoxyacenaphthylene; a halogenated acenaphthylene compound such as 3-chloroacenaphthylene, 3-bromoacenaphthylene, 4-chloroacenaphthylene, 4-bromoacenaphthylene, 5-chloroacenaphthylene, and 5-bromoacenaphthylene, or the like may be exemplified.

As a thermoplastic resin, a polyacrylate resin, a polymethacrylate resin, a polystyrene resin, a polyphenylene ether resin, a polyetherimide resin, a polyethersulfone resin, a polyphenylene sulfide resin, a polycyclopentadiene resin, a polycycloolefin resin, a polycycloolefin copolymer resin, a polyarylate resin, a polyether resin, a phenoxy resin, a polyvinyl acetal resin, a polyolefin resin, a polybutadiene resin, a polyimide resin, a polyamide-imide resin, a polyetherimide resin, a polysulfone resin, a polyethersulfone resin, a polycarbonate resin, a polyether ether ketone resin, a polyester resin, a liquid crystal polyester resin, a fluororesin, a known thermoplastic elastomer such as a styrene-ethylene-propylene copolymer, a styrene-ethylenebutylene copolymer, a styrene-butadiene copolymer, a styrene-isoprene copolymer, a hydrogenated styrene-butadiene copolymer, a hydrogenated styrene-isoprene copolymer, a (meth)acrylonitrile-butadiene-(meth)acrylic acid copolymer, a (meth)acrylonitrile-butadiene-methyl(meth)acrylate copolymer, a methyl(meth)acrylate-butadiene-styrene copolymer (MBS), as well as (meth)acrylonitrile-butadiene rubber (NBR), linear polyurethane, polybutadiene, polyisoprene, fluoro rubber, ethylene-propylene-diene rubber, or the like may be exemplified.

The material of the inorganic filler is not particularly limited, but silica, alumina, glass, cordierite, silicon oxide, barium sulfate, barium carbonate, talc, clay, mica powder, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium zirconate titanate, barium zirconate, calcium zirconate, zirconium phosphate, zirconium tungstate phosphate, or the like may be exemplified. Of these, silica is particularly suitable. In addition, as a silica, spherical silica is preferred. The inorganic filler may be used alone or used by combination of two or more thereof.

The inorganic filler is preferably treated with one or more surface-treating agents such as an amino silane coupling agent, an epoxy silane coupling agent, a mercapto silane coupling agent, a silane coupling agent, an organosilazane compound, a titanate coupling agent, a vinyl silane coupling agent, a methacryloxy silane coupling agent, an acryloxy silane coupling agent, and a styryl silane coupling agent.

As an organic filler, rubber particles, fluororesin particles (fluoropolymer particles), polyamide microparticles, silicone particles, or the like may be exemplified.

As rubber particles, a commercial product may be used, and "EXL-2655" manufactured by Dow Chemical Japan Ltd., "AC3816N" manufactured by Aica Kogyo Co., Ltd., or the like may be exemplified.

As fluororesin particles (fluoropolymer particles), polytetrafluoroethylene (PTFE), perfluoroalkoxyalkane (PFA), perfluoroethylene propene copolymer (FEP), ethylene-tetrafluoroethylene copolymer (ETFE), tetrafluoroethylene-perfluorodioxol copolymer (TFE/PDD), polyvinylidene fluoride (PVDF), polychlorotrifluoroethylene (PCTFE), ethylene-chlorotrifluoroethylene copolymer (ECTFE), polyvinyl fluoride (PVF), or the like may be exemplified. These resins may be used alone or used by combination of two or more thereof.

As fluororesin particles (fluoropolymer particles), a commercial product may be used. Specific examples of PTFE particles, which are commercially available fluoropolymer particles, include "Lubron (registered trademark) L-2" manufactured by Daikin Industries, Ltd., "Lubron L-5" manufactured by Daikin Industries, Ltd., "Lubron L-5F" manufactured by Daikin Industries, Ltd., "Fluon (registered trademark) PTFE L-170JE" manufactured by Asahi Glass Co., Ltd., "Fluon PTFE L-172JE" manufactured by Asahi Glass Co., Ltd., "Fluon PTFE L-173JE" manufactured by Asahi Glass Co., Ltd., "KTL-500F" manufactured by KITAMURA LIMITED, "KTL-2N" manufactured by KITAMURA LIMITED, "KTL-1N" manufactured by KITAMURA LIMITED, and "TLP10F-1" manufactured by Mitsui DuPont Fluorochemicals Co., Ltd.

Surface-treated particles may be contained. As a surface treatment, a surface treatment with a surface-treating agent may be exemplified. The surface-treating agent is not particularly limited. The surface-treating agent includes surfactants such as nonionic surfactants, amphoteric surfactants, cationic surfactants, and anionic surfactants, as well as inorganic microparticles, and the like. From the viewpoint of affinity, a fluorinated surfactant is preferably used as a surface-treating agent. Specific examples of fluorinated surfactants include "SURFLON (registered trademark) S-243" (perfluoroalkyl ethylene oxide adduct) manufactured by AGC Seimi Chemical Co., Ltd., "MEGAFACE (registered trademark) F-251" manufactured by DIC Corporation, "MEGAFACE F-477" manufactured by DIC Corporation, "MEGAFACE F-553" manufactured by DIC Corporation, "MEGAFACE R-40" manufactured by DIC Corporation, "MEGAFACE R-43" manufactured by DIC Corporation, "MEGAFACE R-94" manufactured by DIC Corporation, "FTX-218" manufactured by NEOS Co., Ltd., "FTERGENT (registered trademark) 610FM" manufactured by NEOS Co., Ltd., and "FTERGENT 730LM" manufactured by NEOS Co., Ltd.

The flame retardant is not particularly limited, but a known flame retardant may be used.

Specifically, in fields using halogenated flame retardants such as brominated flame retardants, for example, ethylene dipentabromobenzene, ethylene bis-tetrabromoimide, decabromodiphenyl oxide, and tetradecabromodiphenoxybenzene, which have melting points of 300°C or more, are preferred. The use of halogenated flame retardants is believed to suppress the elimination of halogens at high temperatures, thereby suppressing reduction in heat resistance. In fields requiring halogen-free products, a phosphorus flame retardant such as a phosphate ester flame retardant, a phosphazene flame retardant, and a phosphinate flame retardant may be exemplified. Specific examples of phosphate ester flame retardants include a condensed phosphate ester such as dixylenyl phosphate. Specific examples of phosphazene flame retardants include phenoxyphosphazene. Specific examples of phosphinate flame retardants include a metal salt of phosphinic acid such as an aluminum salt of dialkylphosphinic acid. Each flame retardant exemplified may be used alone or used by combination of two or more thereof.

As other additives, a defoaming agent such as a silicone defoaming agent and an acrylic acid ester defoaming agent, an organometallic compound such as an organocopper compound, an organozinc compound, and an organocobalt compound, an adhesion aid such as a leveling agent and a silane coupling agent, a tackifier, a heat stabilizer, an antistatic agent, a storage stabilizer such as BHT, an antioxidant, a light stabilizer, an ultraviolet absorber, a dye, a pigment, a lubricant, a wetting and dispersing agent, a heavy metal deactivator, an ion trapping agent, an emulsifier, a water dispersion stabilizer, a mold release agent, a wax, a rheology control agent, a surfactant, or the like may be exemplified.

### <Composition ratio of thermosetting resin composition>

The content ratio of component (A) and component (B) in the thermosetting resin composition of the present invention is not particularly limited, but by mass ratio, component (A):component (B) = 99:1 to 1:99, 90:10 to 10:90, 80:20 to 20:80, or the like may be exemplified.

The content of component (C) in the thermosetting resin composition of the present invention is not particularly limited, but an amount that is 0.1 to 10 mass% of the combined amount of component (A) and component (B) may be exemplified.

### <Use mode of thermosetting resin composition>

The thermosetting resin composition of the present invention may be used in a wide range of applications where resin compositions are required, such as solder resists, underfill materials, die bonding materials, semiconductor encapsulation materials, resin plug holes, component embedding resins, and insulating materials for printed wiring boards. The thermosetting resin composition of the present invention is preferably a resin composition for the insulating layer of a printed wiring board. As a printed wiring board, a single sided printed board, a double sided printed board, a multilayer printed board, a flexible printed board, a build-up board, or the like may be exemplified. In addition, the resin composition of the present invention may also be applied to the sheet lamination materials described below. While the resin composition of the present invention may also be applied as a varnish to a printed wiring board to form an insulating layer, industrially, it is generally used to form an insulating layer in the form of a sheet lamination material.

### <Cured product (molded product)>

The cured product obtained by curing the thermosetting resin composition of the present invention may be used as a molding, a laminate, a cast product, an adhesive, a coating, or a film. For example, the cured product of a semiconductor encapsulation material is a cast product or a molding, and as a method for obtaining a cured product for such applications, a curable resin composition may be cast, or molded using a transfer molding machine, an injection molding machine, or the like, and further heated at 80 to 300°C for 0.5 to 10 hours to obtain a cured product.

### <Resin varnish>

The thermosetting resin composition of the present invention may be made into a resin varnish by preparing it in the form of a varnish for the purpose of impregnating a substrate (fibrous substrate) for forming a prepreg when producing a prepreg, or for the purpose of making it a circuit board material for forming a circuit board.

This resin varnish is suitable for circuit boards and may be used as a varnish for circuit board materials. As an application of circuit board materials as used herein, specifically, a printed wiring board, a printed circuit board, a flexible printed wiring board, a build-up wiring board, or the like may be exemplified.

The resin varnish is prepared, for example, as follows.

Each component is added to an organic solvent to be dissolved. Here, heating may be used if necessary. Then, if necessary, the components that do not dissolve in an organic solvent, such as an inorganic filler, are added and dispersed using a ball mill, a bead mill, a planetary mixer, a roll mill, or the like to prepare a curable resin composition in the form of a varnish.

### <Sheet lamination material>

The thermosetting resin composition of the present invention may also be used for a sheet lamination material. As a sheet lamination material, the prepreg, adhesive film, metal foil with a thermosetting resin composition, or the like described below may be exemplified.

### <Prepreg>

The prepreg of the present invention is characterized in that the prepreg comprises a substrate impregnated with the thermosetting resin composition of the present invention.

As the substrate, a fibrous substrate such as glass cloth, aramid cloth, polyester cloth, glass non-woven fabric, aramid non-woven fabric, polyester non-woven fabric, pulp paper, and lint paper may be exemplified. The thickness of the substrate is not particularly limited, but is preferably 20 to 800 µm, and more preferably 20 to 300 µm.

The prepreg of the present invention may be produced by a known method. For example, a method of impregnating a substrate with the resin varnish of the present invention followed by drying may be exemplified.

A prepreg in a semi-cured state (B-stage) may be obtained by heating the substrate impregnated with the resin varnish under desired heating conditions, such as 80 to 170°C for 1 to 10 minutes, to remove the solvent.

### <Adhesive film>

The adhesive film of the present invention is characterized by having a resin composition layer comprising the resin composition of the present invention on a support film. The adhesive film of the present invention may be produced by a known method. For example, the adhesive film may be produced by applying the resin varnish of the present invention to a support film using a die coater or the like, and then drying the organic solvent by heating, hot air blowing, or the like to form a resin composition layer.

The drying conditions are not particularly limited, but drying is performed so that the content of organic solvent in the resin composition layer is 10 mass% or less, preferably 5 mass% or less. While it depends on the amount of organic solvent in the varnish and the boiling point of the organic solvent, for example, a resin composition layer comprising a thermosetting resin composition may be formed by drying a varnish containing 30 to 60 mass% organic solvent at 50 to 150°C for about 3 to 10 minutes.

The thickness of the resin composition layer formed in the adhesive film is not particularly limited, but is preferably 5 to 200 µm. From the viewpoint of having a thin film, it is more preferably 15 to 80 µm.

As the support film, various plastic films such as a film of polyolefin such as polyethylene, polypropylene, and polyvinyl chloride; a film of polyester such as polyethylene terephthalate (hereinafter may be abbreviated as "PET") and polyethylene naphthalate; a polycarbonate film; and a polyimide film. Mold release paper or a metal foil such as copper foil and aluminum foil may also be used. Of these, in terms of versatility, a plastic film is preferred, and a polyethylene terephthalate film is more preferred. On the support and the protective film described below, a surface treatment such as matte treatment or corona treatment may be performed. A mold release treatment may also be performed with a mold release agent such as a silicone resin-based mold release agent, an alkyd resin-based mold release agent, or a fluororesin-based mold release agent.

The thickness of the support film is not particularly limited, but is preferably 10 to 150 µm, and more preferably 25 to 50 µm.

A protective film in accordance with the support may be further laminated on the side of the thermosetting resin composition layer to which the support is not adhered. The thickness of the protective film is not particularly limited, but is, for example, 1 to 40 µm. Laminating a protective film allows to prevent the adhesion of dust or the like to the surface of the resin composition layer, and scratches. The adhesive film may be made into a roll to be stored.

### <Metal foil with a thermosetting resin composition>

The metal foil with a thermosetting resin composition of the present invention is characterized by having a resin composition layer comprising the thermosetting resin composition of the present invention on the metal foil. As the metal foil used herein, copper foil, aluminum foil, or the like may be exemplified. Its thickness is not particularly limited but is preferably in the range of 3 to 200 µm, and more preferably 5 to 105 µm.

The method for producing the metal foil with a thermosetting resin composition of the present invention is not particularly limited, and a method of uniformly dissolving or dispersing the thermosetting resin composition in an aromatic-based or ketone-based solvent, or a mixed solvent thereof, and applying it to the metal foil, followed by drying, may be exemplified. The application may be repeated a plurality of times if necessary, and in this case, the application may be repeated using a plurality of solutions of different compositions and concentrations to ultimately adjust to the desired resin composition and amount of resin.

The thickness of the resin composition layer formed on the metal foil with a thermosetting resin composition of the present invention is not particularly limited, but is preferably 5 to 200 µm.

The metal foil with a thermosetting resin composition of the present invention may be provided with a mold release film on the side of the layer of thermosetting resin composition to which the metal foil is not adhered. As a mold release film, for example, a resin film containing as a main component a polyolefin such as polyethylene or polypropylene; a polyester such as polyethylene terephthalate or polyethylene naphthalate; a polyimide; or a polycarbonate may be used. A silicone resin mold release agent or the like may be applied to the surface of these to adjust the peel strength.

The thickness of the mold release film is preferably 1 to 300 µm, more preferably 5 to 200 µm, still more preferably 10 to 150 µm, and even more preferably 20 to 120 µm.

The mold release film may have a matte treatment, corona treatment, and antistatic treatment performed on the side in contact with the resin sheet.

### <Laminate with a metal foil>

The laminate with a metal foil of the present invention is provided with a layer of the thermosetting resin of the present invention, and a metal foil. As the metal foil used herein, copper foil, aluminum foil, or the like may be exemplified. Its thickness is not particularly limited but is in the range of preferably 3 to 200 µm, and more preferably 5 to 105 µm.

The method for producing the laminate with a metal foil of the present invention is not particularly limited, but a method of laminating the sheet lamination material of the present invention described above and a metal foil in a layer configuration according to the purpose, bonding the layers together under heat and pressure, and thermally curing at the same time, may be exemplified. In the laminate with a metal foil of the present invention, a layer of the thermosetting resin of the present invention and a metal foil are laminated in any layer configuration. The metal foil may be used as a surface layer or as an intermediate layer. In addition to the above, multilayering may also be performed by repeating lamination and curing a plurality of times.

An adhesive may also be used for bonding the metal foil. As the adhesive, an epoxy, acrylic, phenolic, or cyanoacrylate adhesive may be exemplified, but it is not particularly limited thereto. The resin composition of the present invention may also be used as an adhesive. The above laminate molding and curing may be performed under the similar conditions as the production of the insulator for a printed wiring board of the present invention.

The thermosetting resin composition of the present invention may be processed into a molding material, a sheet, or a film, and may be used for low-dielectric materials, insulating materials, heat-resistant materials, structural materials, and the like that can satisfy properties such as low dielectric constant, low water absorption, and high heat resistance in the fields of electrical industry, space/aircraft industry, automobiles and the like. In particular, the composition may be used as a single sided, double sided, or multilayer printed board, a flexible printed board, a build-up board, or the like. In addition, the composition may be applied to semiconductor-related materials or optical materials, and furthermore, to paints, photosensitive materials, adhesives, wastewater treatment agents, heavy metal scavengers, ion exchange resins, antistatic agents, antioxidants, antifogging agents, antirust agents, resisting agents, fungicides, insecticides, biomedical materials, flocculants, surfactants, lubricants, solid fuel binders, conductivity agents, resin modifiers, asphalt modifying plasticizers, sintering binders, and the like.

The thermosetting resin composition of the present invention is a thermosetting resin composition that has a low dielectric constant, a low dielectric loss tangent, and a high glass transition point, and exhibits excellent water resistance. Therefore, a cured molded article free from molding defect phenomena such as warpage may be provided as a dielectric material, insulating material, heat-resistant material, structural material, and the like, in the fields of electric/electronic industry, space/aircraft industry, and the like, in response to the recent strong demand for smaller and thinner products.

Examples of the present invention will be described below, but the technical scope of the present invention is not limited to these Examples.

### Examples

### (Synthesis Example 1)

### Synthesis of N,N-bis(4-(tert-butyl)phenyl)acrylamide (DtBPAm)

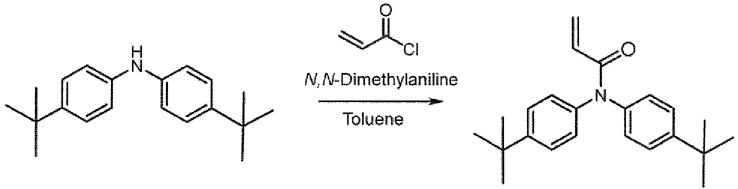

To a nitrogen-purged 1-L four-neck flask were added bis(4-tert-butylphenyl)amine (100 g, 0.355 mol), N,N-dimethylaniline (64.59 g, 0.533 mol), and 400 mL of super dehydrated toluene, and the mixture was stirred until uniformly dissolved. Next, the reaction solution was cooled to 0°C or less in an ice/ethanol bath, then acrylic acid chloride (38.59 g, 0.426 mol) was slowly added dropwise, and the mixture was stirred for 30 minutes. The reaction solution was then heated to room temperature and the reaction was carried out for 24 hours. After completion of the reaction, the product was washed with 1N hydrochloric acid solution, saturated sodium bicarbonate solution, and brine. The organic layer was dehydrated with magnesium sulfate, and then the filtrate was distilled off with an evaporator. The resulting crude product was purified by recrystallization with hexane to give N,N-bis(4-(tert-butyl)phenyl)acrylamide (92.90 g, 79% yield).

### (Synthesis Example 2)

### Synthesis of N,N-bis(4-(1,1,3,3-tetramethylbutyl)phenyl)acrylamide (DODPAm)

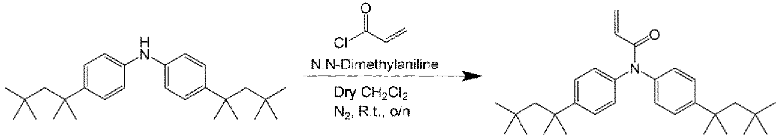

To a nitrogen-purged 1-L four-neck flask were added bis[4-(1,1,3,3-tetramethylbutyl)phenyl]amine (50.00 g, 0.127 mol), N,N-dimethylaniline (46.17 g, 0.381 mol), and 477 mL of super dehydrated dichloromethane, and the mixture was stirred until uniformly dissolved. Next, the reaction solution was cooled to 0°C or less in an ice/ethanol bath, then acrylic acid chloride (22.99 g, 0.254 mol) was slowly added dropwise, and the mixture was stirred for 30 minutes. The reaction solution was then heated to room temperature and the reaction was carried out for 24 hours. After completion of the reaction, the solvent was distilled off with an evaporator and the crude product was dissolved in 250 mL of ethyl acetate. The product was then washed with 1N hydrochloric acid solution, saturated sodium bicarbonate solution, and brine. The organic layer was dehydrated with magnesium sulfate, and then the filtrate was distilled off with an evaporator. The resulting crude product was purified by recrystallization with hexane to give DODPA (38.67 g, 68% yield). The results of mass spectrometry are shown below. High Resolution ESI-TOF-MS m/z Calcd. for [C₃₁H₄₅NO([M+Na]⁺)]: 470.3393 found 470.3317.

### (Synthesis Example 3)

### Synthesis of N,N-[4,4'-bis(α,α-dimethylbenzyl)diphenyl]acrylamide (DBnDPAm)

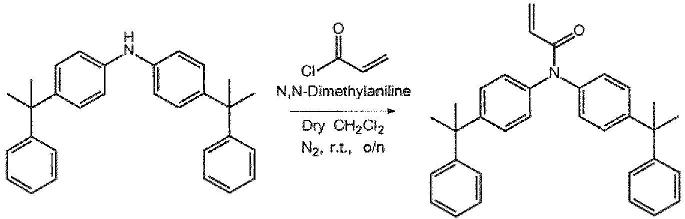

To a nitrogen-purged 500-mL four-neck flask were added 4,4'-bis(α,α-dimethylbenzyl)diphenylamine (25.00 g, 0.061 mol), N,N-dimethylaniline (14.90 g, 0.123 mol), and 200 mL of super dehydrated dichloromethane, and the mixture was stirred until uniformly dissolved. Next, the reaction solution was cooled to 0°C or less in an ice/ethanol bath, then acrylic acid chloride (6.69 g, 0.074 mol) was slowly added dropwise, and the mixture was stirred for 30 minutes. The reaction solution was then heated to room temperature and the reaction was carried out for 24 hours. After completion of the reaction, the solvent was distilled off with an evaporator and the crude product was dissolved in 250 mL of ethyl acetate. The product was then washed with 1N hydrochloric acid solution, saturated sodium bicarbonate solution, and brine. The organic layer was dehydrated with magnesium sulfate, and then the filtrate was distilled off with an evaporator. The resulting crude product was purified by recrystallization with hexane to give N,N-[4,4'-bis(α,α-dimethylbenzyl)diphenyl]acrylamide (22.95 g, 81% yield). The results of mass spectrometry are shown below. High Resolution ESI-TOF-MS m/z Calcd. for [C₃₁H₄₅NO([M+Na]⁺)]: 482.2454 found 482.2411.

### (Synthesis Example 4)

### Preparation of styrene-isoprene-divinylbenzene (St-IP-DVB) copolymer (component B-5)

Methylcyclohexane (180.53 g) and THF (20.36 g) were placed in a thoroughly nitrogen-purged 500-mL four-neck flask, to which n-BuLi (4.50 g, 10.33 mmol) was added at an internal temperature of 2.6°C, and the mixture was stirred. Next, styrene (10.91 g, 104.75 mmol) was added dropwise, and after the dropwise addition, the mixture was stirred for 10 minutes. Subsequently, isoprene (28.08 g, 412.21 mmol) was added dropwise, and after the dropwise addition, the mixture was stirred for 30 minutes. Then, styrene (10.99 g, 105.52 mmol) was added dropwise, and after the dropwise addition, the mixture was stirred for 10 minutes. Subsequently, diethylzinc (7.49 g, 10.31 mmol) was added, the mixture was stirred, and divinylbenzene (26.36 g, 161.98 mmol) was added dropwise. After the dropwise addition, the mixture was stirred for 5 minutes, and then methanol was added for killing. The polymerization solution was separated and washed once with 3% aqueous acetic acid solution and twice with pure water, then added dropwise to methanol while stirring, and then further stirred for 2 hours after the dropwise addition. The solution was decanted, and the polymer was air-dried under nitrogen stream, then dried under reduced pressure at room temperature. Yield: 58.53 g, Mw=7,386, Mw/Mn=1.06

### (Examples 1 to 38 and Comparative Examples 1 to 11)

Each reagent was added to toluene in the composition (parts by mass) of Tables 1 to 12 to obtain a solid concentration of 50 mass%, and then mixed. The resulting liquid toluene was then removed with an evaporator to obtain a powdered resin composition. The resin composition was cured by heat pressing at 200°C for 90 minutes. The physical properties of the resulting cured product were measured for the following items, and the results are shown in Table 1.

### <Glass transition temperature (Tg)/TMA>

The glass transition temperature (Tg) by the TMA method was evaluated in accordance with IPC TM650. A thermomechanical analysis (TMA) device (Discovery TMA450 EM manufactured by TA Instruments Japan, Inc.) was used for the measurements, which were made in the range of 0 to 200°C.

### <Glass transition temperature (Tg)/DMA>

A dynamic viscoelastic measurement (DMA) was performed, and the temperature at which tanδ was maximum when heating from room temperature to 270°C at a temperature increase rate of 5°C/min was used as Tg. The device used was RAS-G2 manufactured by TA Instruments Japan, Inc.

### <Dielectric loss tangent test before water absorption test>

The measurements were performed at 10 GHz using a cylindrical cavity resonator (TE mode resonator) manufactured by AET, Inc.

### <Dielectric loss tangent after water absorption treatment>

The cured product used in the measurement of the dielectric loss tangent before water absorption treatment described above was immersed in water for 24 hours at room temperature in accordance with JIS K7209. After the water absorption treatment, the water on the cured product was thoroughly wiped off with a dry, clean cloth. The dielectric loss tangent of this cured product subjected to a water absorption treatment (dielectric loss tangent after water absorption) was measured by the similar method as the measurement of the dielectric loss tangent before water absorption treatment described above.

### <Change in dielectric loss tangent (after water absorption treatment - before water absorption treatment)>

The difference between the dielectric loss tangent before water absorption treatment and the dielectric loss tangent after water absorption treatment (dielectric loss tangent after water absorption treatment - dielectric loss tangent before water absorption treatment) was calculated.

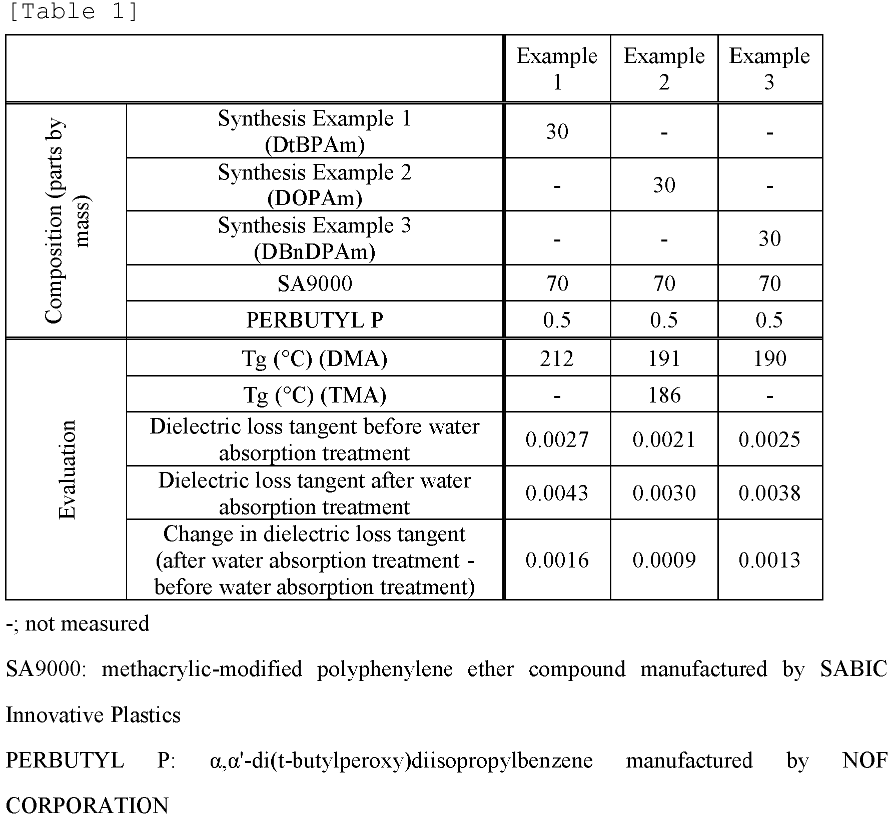

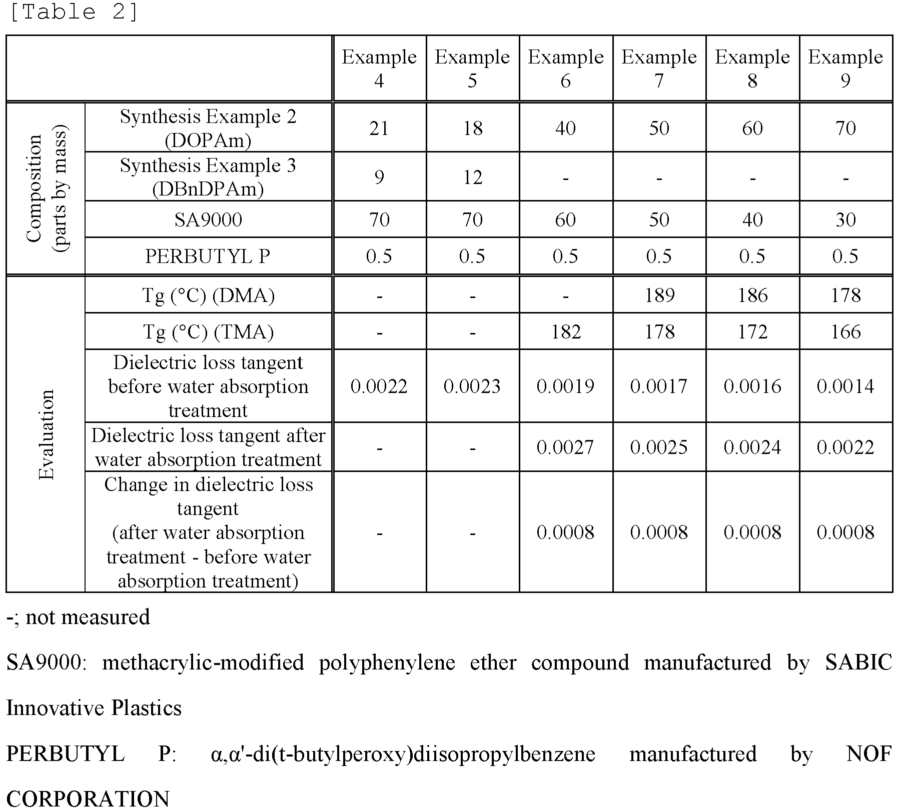

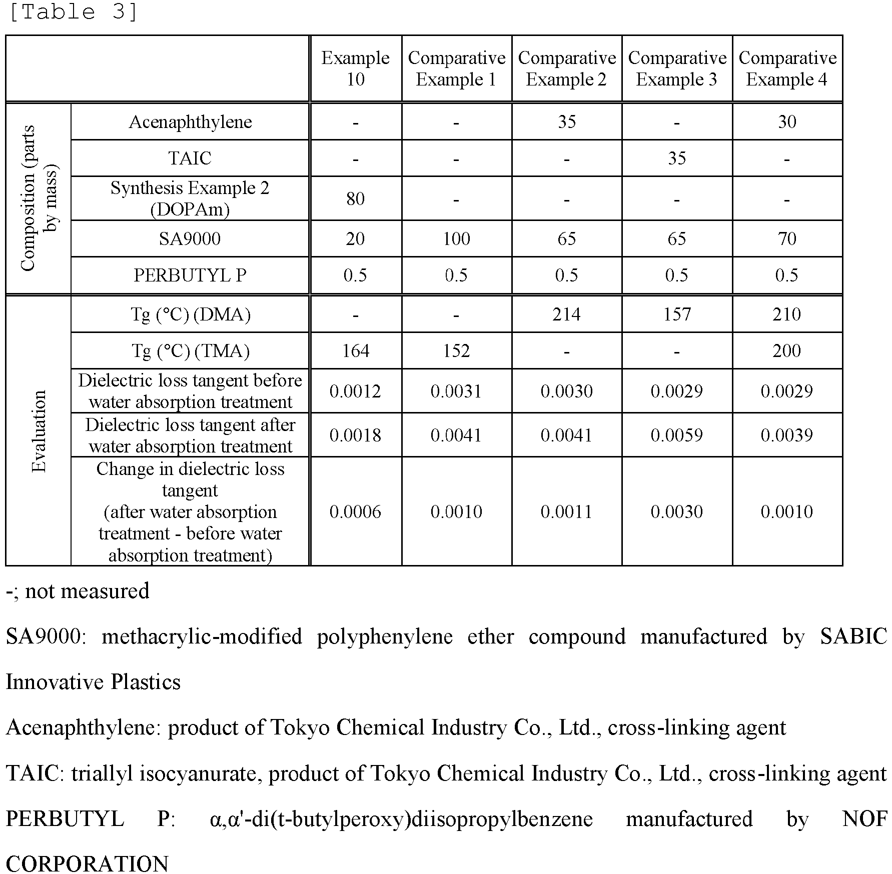

**[Table 4]**

| | | Example 11 | Example 12 | Example 13 | Example 14 | Example 15 | Comparative Example 5 |
|---|---|---|---|---|---|---|---|
| Composition (parts by mass) | Synthesis Example 2 (DOPAm) | 60 | 50 | 40 | 30 | 20 | 0 |
| | NISSO-PB B-3000 | 40 | 50 | 60 | 70 | 80 | 100 |
| | PERCUMYL D | 2 | 2 | 2 | 2 | 2 | 2 |
| Evaluation | Tg (°C) (DMA) | - | - | - | 181 | - | - |
| | Tg (°C) (TMA) | 155 | 140 | 139 | 127 | 63 | 6 |
| | Dielectric loss tangent before water absorption treatment | 0.0009 | 0.0009 | 0.0010 | 0.0011 | 0.0014 | 0.0017 |
| | Dielectric loss tangent after water absorption treatment | 0.0012 | 0.0013 | 0.0014 | 0.0015 | 0.0019 | 0.0039 |
| | Change in dielectric loss tangent (after water absorption treatment - before water absorption treatment) | 0.0003 | 0.0004 | 0.0004 | 0.0004 | 0.0005 | 0.0022 |

| | | | | | | | |
|---|---|---|---|---|---|---|---|
| -; not measured NISSO-PB B-3000: liquid polybutadiene manufactured by Nippon Soda Co., Ltd. PERCUMYL D: dicumyl peroxide manufactured by NOF CORPORATION | | | | | | | |

**[Table 5]**

| | | Example 16 | Example 17 | Example 18 | Example 19 | Example 20 |
|---|---|---|---|---|---|---|
| | | | | | | |
| Composition (parts by mass) | Synthesis Example 1 (DtBPAm) | 50 | 40 | 30 | 20 | 10 |
| | NISSO-PB B-3000 | 50 | 60 | 70 | 80 | 90 |
| | PERCUMYL D | 2 | 2 | 2 | 2 | 2 |
| Evaluation | Tg (°C) (DMA) | - | - | - | - | - |
| | Tg (°C) (TMA) | 203 | 173 | 143 | 96 | 40 |
| | Dielectric loss tangent before water absorption treatment | - | 0.0019 | 0.0016 | 0.0014 | 0.0013 |
| | Dielectric loss tangent after water absorption treatment | - | 0.0025 | 0.0023 | 0.0021 | 0.0031 |
| | Change in dielectric loss tangent (after water absorption treatment - before water absorption treatment) | - | 0.0006 | 0.0007 | 0.0007 | 0.0018 |

| | | | | | | |
|---|---|---|---|---|---|---|
| -; not measured NISSO-PB B-3000: liquid polybutadiene manufactured by Nippon Soda Co., Ltd. PERCUMYL D: dicumyl peroxide manufactured by NOF CORPORATION | | | | | | |

**[Table 6]**

| | | II Example 21 |
|---|---|---|
| Composition (parts by mass) | Synthesis Example 3 (DBnDPAm) | 50 |
| | NISSO-PB B-3000 | 50 |
| | PERCUMYL D | 2 |
| Evaluation | Tg (°C) (DMA) | - |
| | Tg (°C) (TMA) | 25 |
| | Dielectric loss tangent before water absorption treatment | 0.0014 |
| | Dielectric loss tangent after water absorption treatment | 0.0016 |
| | Change in dielectric loss tangent (after water absorption treatment - before water absorption treatment) | 0.0002 |

| | | |
|---|---|---|
| -; not measured NISSO-PB B-3000: liquid polybutadiene manufactured by Nippon Soda Co., Ltd. PERCUMYL D: dicumyl peroxide manufactured by NOF CORPORATION | | |

**[Table 7]**

| | | Example 22 | Example 23 | Example 24 | Example 25 | Comparative Example 6 |
|---|---|---|---|---|---|---|
| Composition (parts by mass) | Synthesis Example 2 (DOPAm) | 60 | 50 | 40 | 30 | 0 |
| | Liquid 1,2-SBS | 40 | 50 | 60 | 70 | 100 |
| | PERCUMYL D | 2 | 2 | 2 | 2 | 2 |
| Evaluation | Tg (°C) (DMA) | - | - | - | - | - |
| | Tg (°C) (TMA) | 136 | 114 | 93 | 77 | 56 |
| | Dielectric loss tangent before water absorption treatment | - | 0.0010 | 0.0011 | 0.0011 | 0.0014 |
| | Dielectric loss tangent after water absorption treatment | - | 0.0014 | 0.0015 | 0.0015 | 0.0030 |
| | Change in dielectric loss tangent (after water absorption treatment - before water absorption treatment) | - | 0.0004 | 0.0004 | 0.0004 | 0.0016 |

| | | | | | | |
|---|---|---|---|---|---|---|
| -; not measured Liquid 1,2-SBS: styrene-butadiene-styrene resin manufactured by Nippon Soda Co., Ltd., molecular weight: 4,500, styrene content: 20%, ratio of 1,2-bond structures in butadiene block: 80% or more PERCUMYL D: dicumyl peroxide manufactured by NOF CORPORATION | | | | | | |

**[Table 8]**

| | | Example 26 | Example 27 | Example 28 | Example 29 | Comparative Example 7 |
|---|---|---|---|---|---|---|
| Composition (parts by mass) | Synthesis Example 2 (DOPAm) | 60 | 50 | 40 | 30 | 0 |
| | Solid 1,2-SBS | 40 | 50 | 60 | 70 | 100 |
| | PERCUMYL D | 2 | 2 | 2 | 2 | 2 |
| Evaluation | Tg (°C) (DMA) | - | - | - | - | - |
| | Tg (°C) (TMA) | 140 | 134 | 121 | 107 | 87 |
| | Dielectric loss tangent before water absorption treatment | - | 0.0009 | 0.0010 | 0.0011 | 0.0017 |
| | Dielectric loss tangent after water absorption treatment | - | 0.0012 | 0.0013 | 0.0014 | 0.0022 |
| | Change in dielectric loss tangent (after water absorption treatment - before water absorption treatment) | - | 0.0003 | 0.0003 | 0.0003 | 0.0005 |

| | | | | | | |
|---|---|---|---|---|---|---|
| -; not measured Solid 1,2-SBS: styrene-butadiene-styrene resin manufactured by Nippon Soda Co., Ltd., molecular weight: 35,000, styrene content: 50%, ratio of 1,2-bond structures in butadiene block: 80% or more PERCUMYL D: dicumyl peroxide manufactured by NOF CORPORATION | | | | | | |

**[Table 9]**

| | | Example 30 | Example 31 | Example 32 | Comparative Example 8 |
|---|---|---|---|---|---|
| Composition (parts by mass) | Synthesis Example 2 (DOPAm) | 50 | 40 | 30 | 0 |
| | SA9000 | 50 | 60 | 70 | 100 |
| | PERBUTYL P | 2 | 2 | 2 | 2 |
| Evaluation | Tg (°C) (DMA) | 195 | 198 | 201 | 205 |
| | Tg (°C) (TMA) | 177 | 182 | 186 | 186 |
| | Dielectric loss tangent before water absorption treatment | 0.0028 | 0.0032 | 0.0034 | 0.0051 |
| | Dielectric loss tangent after water absorption treatment | 0.0040 | 0.0047 | 0.0051 | 0.0078 |
| | Change in dielectric loss tangent (after water absorption treatment - before water absorption treatment) | 0.0012 | 0.0015 | 0.0017 | 0.0027 |

| | | | | | |
|---|---|---|---|---|---|
| SA9000: methacrylic-modified polyphenylene ether compound manufactured by SABIC Innovative Plastics PERBUTYL P: α,α'-di(t-butylperoxy)diisopropylbenzene manufactured by NOF CORPORATION | | | | | |

**[Table 10]**

| | | Example 33 | Example 34 | Example 35 | Comparative Example 9 |
|---|---|---|---|---|---|
| Composition (parts by mass) | Synthesis Example 2 (DOPAm) | 50 | 40 | 30 | 0 |
| | OPE-2St | 50 | 60 | 70 | 100 |
| Evaluation | Tg (°C) (DMA) | 204 | 202 | 202 | 204 |
| | Tg (°C) (TMA) | 175 | 179 | 183 | 190 |
| | Dielectric loss tangent before water absorption treatment | 0.0014 | 0.0015 | 0.0016 | 0.0020 |
| | Dielectric loss tangent after water absorption treatment | 0.0024 | 0.0028 | 0.0032 | 0.0047 |
| | Change in dielectric loss tangent (after water absorption treatment - before water absorption treatment) | 0.0010 | 0.0013 | 0.0016 | 0.0027 |

| | | | | | |
|---|---|---|---|---|---|
| OPE-2St: oligophenylene ether resin manufactured by Mitsubishi Gas Chemical Company | | | | | |

**[Table 11]**

| | | Example 36 | Example 37 | Comparative Example 10 |
|---|---|---|---|---|
| Composition (parts by mass) | Synthesis Example 2 (DOPAm) | 40 | 30 | 0 |
| | MIR-3000 | 60 | 70 | 100 |
| | PERCUMYL D | 2 | 2 | 2 |
| Evaluation | Tg (°C) (DMA) | >300 | >300 | >300 |
| | Tg (°C) (TMA) | 240 | 248 | 245 |
| | Dielectric loss tangent before water absorption treatment | 0.0025 | 0.0029 | 0.0036 |
| | Dielectric loss tangent after water absorption treatment | 0.0077 | 0.0091 | 0.0229 |
| | Change in dielectric loss tangent (after water absorption treatment - before water absorption treatment) | 0.0051 | 0.0062 | 0.0193 |

| | | | | |
|---|---|---|---|---|
| MIR-3000: maleimide resin manufactured by Nippon Kayaku Co., Ltd. PERCUMYL D: dicumyl peroxide manufactured by NOF CORPORATION | | | | |

**[Table 12]**

| | | Example 38 | Comparative Example 11 |
|---|---|---|---|
| Composition (parts by mass) | Synthesis Example 2 (DOPAm) | 30 | 0 |
| | Synthesis Example 4 (St-IP-DVB) | 70 | 100 |
| | PERCUMYL D | 2 | 2 |
| Evaluation | Tg (°C) (DMA) | - | 32 |
| | Tg (°C) (TMA) | 81 | 30 |
| | Dielectric loss tangent before water absorption treatment | 0.0016 | 0.0021 |
| | Dielectric loss tangent after water absorption treatment | 0.0019 | 0.0028 |
| | Change in dielectric loss tangent (after water absorption treatment - before water absorption treatment) | 0.0003 | 0.0007 |

| | | | |
|---|---|---|---|
| -; not measured PERCUMYL D: dicumyl peroxide manufactured by NOF CORPORATION | | | |

## Claims

1. A thermosetting resin composition comprising:
(A) at least one compound of formula (I): 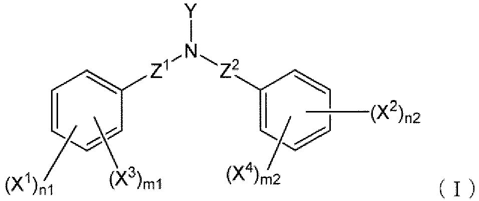 (wherein
X¹ and X² each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group,
n1 and n2 each independently represent 0 or 1,
Z¹ and Z² each independently represent a single bond or a C1-C3 alkylene group,
X³ and X⁴ each independently represent an organic group or a halogeno group,
m1 and m2 each independently represent any integer from 0 to 4, and
Y represents a polymerizable functional group), and
(B) at least one of the following (B-1) to (B-5):
(B-1) a maleimide compound having one or more maleimide groups;
(B-2) a polyphenylene ether compound;
(B-3) polybutadiene having a molar ratio of 1,2-bond structure to 1,4-bond structure of 80:20 to 100:0;
(B-4) a styrene-butadiene-styrene block copolymer (SBS) having a molar ratio of 1,2-bond structure to 1,4-bond structure in the butadiene block of 80:20 to 100:0; and
(B-5) a polymer having a repeat unit of formula (III) in the molecule: 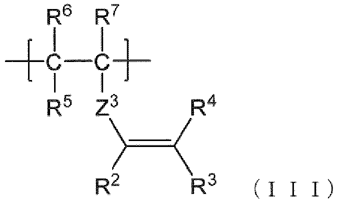 (wherein Z³ represents a C6-C12 arylene group, R² to R⁴ each independently represent a hydrogen atom or a C1-C6 alkyl group, and R⁵ to R⁷ each independently represent a hydrogen atom or a C1-C6 alkyl group).

2. The thermosetting resin composition according to claim 1, further comprising (C) a radical polymerization initiator.

3. The thermosetting resin composition according to claim 1 or 2, wherein the compound of formula (I) is a compound of formula (II): 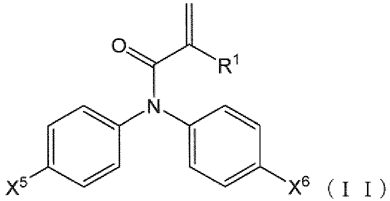 (wherein
X⁵ and X⁶ each independently represent a C1-C20 alkyl group, a C1-C20 alkoxy group, a C3-C6 cyclic alkyl group, a C3-C6 cyclic alkoxy group, a benzyl group, or an α,α-dimethylbenzyl group, and
R¹ represents a hydrogen atom or a methyl group).

4. A cured product made by curing the thermosetting resin composition according to claim 1 or 2.

5. The thermosetting resin composition according to claim 1 or 2, wherein the thermosetting resin composition is a resin composition for the insulating layer of a printed wiring board.

6. A resin varnish comprising the thermosetting resin composition according to claim 1 or 2.

7. A prepreg comprising a substrate impregnated with the thermosetting resin composition according to claim 1 or 2.

8. An adhesive film having a resin composition layer comprising the thermosetting resin composition according to claim 1 or 2 on a support film.

9. A metal foil with a thermosetting resin composition, having a resin composition layer comprising the thermosetting resin composition according to claim 1 or 2 on the metal foil.

10. A laminate with a metal foil, comprising:
a layer of a cured product of the thermosetting resin composition according to claim 1 or 2; and
a metal foil.
